# EUROPÄISCHE PATENTSCHRIFT

(11) **EP 2 630 509 B1**
(45) Veröffentlichungstag und Bekanntmachung des Hinweises auf die Patenterteilung: **08.09.2021**
(21) Anmeldenummer: 11802328.2
(22) Anmeldetag: 08.12.2011
(51) Int. Cl.: G01R 31/34

(54) **ÜBERWACHUNG UND FEHLERDIAGNOSE EINER ELEKTRISCHEN MASCHINE**
MONITORING AND FAULT DIAGNOSIS OF AN ELECTRIC MACHINE
SURVEILLANCE ET DIAGNOSTIC D'ERREUR D'UNE MACHINE ÉLECTRIQUE

(30) Priorität: 21.12.2010 DE 102010063759; 19.07.2011 DE 102011079398
(43) Veröffentlichungstag der Anmeldung: 28.08.2013
(73) Patentinhaber: Siemens Aktiengesellschaft, 80333 München (DE)
(72) Erfinder: LEPPICH, André, 91074 Herzogenaurach-Haundorf (DE); LUFT, Markus, 63741 Aschaffenburg (DE); ROSSMANN, Jürgen, 91710 Gunzenhausen (DE); STUKENKEMPER, Alexander, Cumming, GA 30041-1150 (US)
(86) Internationale Anmeldenummer: PCT/EP2011/072224
(87) Internationale Veröffentlichungsnummer: WO 2012/084535

(56) Entgegenhaltungen:
- EP-B1- 0 961 130
- US-A1- 2006 006 879
- US-B1- 6 172 509
- PILLAY P ET AL: "Motor current signature analysis", CONFERENCE RECORD OF THE 1996 IEEE INDUSTRY APPLICATIONS CONFERENCE - 31ST IAS ANNUAL MEETING, IEEE SERVICE CENTER, US, Bd. 1, 6. Oktober 1996 (1996-10-06), Seiten 587-594, XP010201177, DOI: 10.1109/IAS.1996.557096 ISBN: 978-0-7803-3544-8
- DIMITROV L V ET AL: "Diagnosis of rotor faults of induction motors, operated in non-rated conditions", ELECTRONICS TECHNOLOGY: MEETING THE CHALLENGES OF ELECTRONICS TECHNOLO GY PROGRESS, 2004. 27TH INTERNATIONAL SPRING SEMINAR ON BANKYA, BULGARIA 13-16 MAY 2004, PISCATAWAY, NJ, USA,IEEE, US, Bd. 1, 13. Mai 2004 (2004-05-13), Seiten 110-113, XP010818580, ISBN: 978-0-7803-8422-4
- None

## Beschreibung

Die Erfindung betrifft ein Verfahren zur Überwachung und Fehlerdiagnose einer rotierenden elektrischen Maschine, die durch einen Umrichter gespeist wird.

Zur Überwachung und Fehlerdiagnose rotierender elektrischer Maschinen sind Zustandsüberwachungsverfahren bekannt, um elektrische oder mechanische Schäden an einer derartigen Maschine zu diagnostizieren.

EP 0 961 130 B1 offenbart ein Verfahren zur Früherkennung von Läuferschäden bei Asynchronmaschinen unter Heranziehung zweier Motorströme als Messsignale. Dabei wird eine Spektralanalyse dieser Motorströme durchgeführt und für die Ermittlung spektraler Störkomponenten als Kenngrößen der Läuferschädigung verwendet.

Der Erfindung liegt die Aufgabe zugrunde, ein verbessertes Verfahren zur Überwachung und Fehlerdiagnose einer umrichtergespeisten rotierenden elektrischen Maschine anzugeben.

Die Aufgabe wird erfindungsgemäß durch die Merkmale des Anspruchs 1 gelöst.

Vorteilhafte Ausgestaltungen der Erfindung sind Gegenstand der Unteransprüche.

Bei dem erfindungsgemäßen Verfahren zur Überwachung und Fehlerdiagnose einer rotierenden elektrischen Maschine, die durch einen Umrichter gespeist wird, wird eine Stromsignatur von Ausgangssignalen des Umrichters aufgenommen und es wird eine Transformation der Stromsignatur durchgeführt, die wenigstens eine schnelle Fourier-Transformation unter Verwendung einer Filterfunktion umfasst. Die transformierte Stromsignatur wird in zumindest einem Frequenzband zur Erkennung eines Schadens an der Maschine ausgewertet.

Unter einer Stromsignatur wird dabei ein zeitlicher Verlauf eines elektrischen Stromes verstanden. Unter Stromsignaturen von Ausgangssignalen eines Umrichters werden dementsprechend zeitliche Verläufe von elektrischen Strömen verstanden, die von dem Umrichter ausgegeben werden und eine von ihm gespeiste elektrische Maschine versorgen.

Bei dem Verfahren werden somit Ausgangssignale (elektrische Ströme) eines Umrichters analysiert. Das Verfahren nutzt vorteilhaft aus, dass bereits kleine Schäden an einer umrichtergespeisten Maschine auf die Ausgangssignale des Umrichters rückwirken und daher durch eine Analyse dieser Ausgangssignale erkannt werden können. Die Verwendung einer schnellen Fourier-Transformation ermöglicht vorteilhaft die Erkennung von Schäden durch signifikante Änderungen des Fourierspektrums der aufgenommenen Ausgangssignale. Die Verwendung einer Filterfunktion ermöglicht dabei vorteilhaft das Herausfiltern von Störsignalen und vereinfacht dadurch die Analyse des Fourierspektrums.

Die Erfindung ermöglicht es somit, kleine Schäden an einer umrichtergespeisten Maschine frühzeitig zu erkennen, d.h. bevor die Maschine stark geschädigt oder ganz zerstört wird. Dadurch kann eine rechtzeitige Beseitigung kleiner Schäden veranlasst und eine starke Schädigung oder eine Zerstörung der Maschine verhindert werden. Dies führt auch zu einer erhöhten Maschinenverfügbarkeit, da die Reparatur starker Schäden oder die Ersetzung einer zerstörten Maschine zeitaufwändig sind.

Laut der Erfindung wird eine transformierte Referenzstromsignatur ermittelt, die einen schadensfreien Zustand der Maschine repräsentiert, und die transformierte Stromsignatur bei der Auswertung mit der transformierten Referenzstromsignatur verglichen.

Durch Vergleich der transformierten Stromsignatur mit der transformierten Referenzstromsignatur können Schäden an der Maschine vorteilhaft schnell als signifikante Abweichungen von der transformierten Referenzstromsignatur erkannt werden.

Zusätzlich wird zur Erkennung eines Schadens an der Maschine in einem Wertebereich der transformierten Stromsignatur ein frequenzabhängiges Toleranzband vorgegeben und auf einen Schaden geschlossen, wenn die transformierte Stromsignatur bei wenigstens einer Frequenz außerhalb des Toleranzbandes liegt. Das Toleranzband wird dabei so vorgegeben, dass die transformierte Referenzstromsignatur innerhalb des Toleranzbandes liegt, sofern eine Referenzstromsignatur ermittelt wurde.

Das Toleranzband gibt frequenzabhängig einen Bereich von Werten der transformierten Stromsignatur an, für die die Maschine als schadensfrei beurteilt wird. Durch die Vorgabe des Toleranzbandes kann somit schnell und automatisch ein Schaden an der Maschine diagnostiziert werden, sobald die transformierte Stromsignatur das Toleranzband verlässt.

In einer weiteren zusätzlichen Ausgestaltung der Erfindung wird für wenigstens eine Schadensart eine schadensspezifische transformierte Stromsignatur ermittelt und die transformierte Stromsignatur wird bei der Auswertung mit wenigstens einer schadensspezifischen transformierten Stromsignatur verglichen.

Auf diese Weise kann mittels des Verfahrens nicht nur ein Schaden an der Maschine erkannt werden, sondern es kann auch auf die Art eines Schadens geschlossen werden, wenn die transformierte Stromsignatur mit einer bekannten schadensspezifischen transformierten Stromsignatur übereinstimmt.

Dabei wird eine schadensspezifische transformierte Stromsignatur wenigstens für einen Rotorstabbruch eines Rotors der elektrischen Maschine, für eine Feldasymmetrie des Rotors, für eine Exzentrizität des Rotors, für einen Statorwindungsschluss eines Stators der elektrischen Maschine oder für einen Schaden eines Antriebsstranges der elektrischen Maschine ermittelt.

Dadurch können insbesondere die angegebenen Schäden erkannt werden. Dies ist vorteilhaft, da derartige Schäden häufig zu Folgeschäden elektrischer Maschinen bis hin zu deren Zerstörung führen.

Weiterhin werden für einen dreiphasigen Umrichterstrom vorzugsweise alle drei Phasenströme aufgenommen und die Transformation der Stromsignatur umfasst die Bildung einer symmetrischen Komponente aus den drei Phasenströmen. Unter einer symmetrischen Komponente wird dabei ein Mitsystem, ein Gegensystem oder ein Nullsystem der Phasenströme verstanden.

Die Bildung und Untersuchung einer symmetrischen Komponente vereinfacht die Analyse eines dreiphasigen Umrichterstroms gegenüber der Analyse der einzelnen Phasenströme. Insbesondere vereinfacht es die Analyse eines unbalancierten Fehlers in einem Drehstromsystem.

Ferner umfasst die Transformation der Stromsignatur vorzugsweise eine Amplitudendemodulation, welche beispielsweise mit einer Hilberttransformation der fouriertransformierten Stromsignatur durchgeführt wird.

Die Amplitudendemodulation erleichtert die Erkennung von signifikanten Änderungen der transformierten Stromsignatur und damit deren Analyse.

Vorzugsweise wird die elektrische Maschine ferner mit dem erfindungsgemäßen Verfahren laufend und automatisch überwacht und es wird automatisch eine Fehlermeldung generiert und/oder ein Alarm ausgelöst, wenn ein Schaden an der Maschine erkannt wird.

Dadurch kann ein Schaden vorteilhaft unmittelbar nach seiner Entstehung erkannt werden und Folgeschäden können minimiert werden.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung eines Ausführungsbeispiels, das im Zusammenhang mit den Zeichnungen näher erläutert wird. Dabei zeigen:
- FIG 1: schematisch eine elektrische Maschine mit einem Asynchronmotor,
- FIG 2: aufgenommene Stromsignaturen von Ausgangssignalen eines Umrichters, der einen Asynchronmotor speist,
- FIG 3: eine transformierte Stromsignatur eines Umrichters, der einen schadensfreien Asynchronmotor speist,
- FIG 4: eine transformierte Stromsignatur eines Umrichters, der einen Asynchronmotor mit einem Rotorstabbruch speist,
- FIG 5: eine transformierte Stromsignatur eines Umrichters, der einen schadensfreien Asynchronmotor speist, in einem ersten Freqenzband,
- FIG 6: eine transformierte Stromsignatur eines Umrichters, der einen schadensfreien Asynchronmotor speist, in einem zweiten Freqenzband,
- FIG 7: eine transformierte Stromsignatur eines Umrichters, der einen Asynchronmotor mit einem Rotorstabbruch speist, in einem ersten Freqenzband, und
- FIG 8: eine transformierte Stromsignatur eines Umrichters, der einen Asynchronmotor mit einem Rotorstabbruch speist, in einem zweiten Freqenzband.

Einander entsprechende Teile sind in allen Figuren mit den gleichen Bezugszeichen versehen.

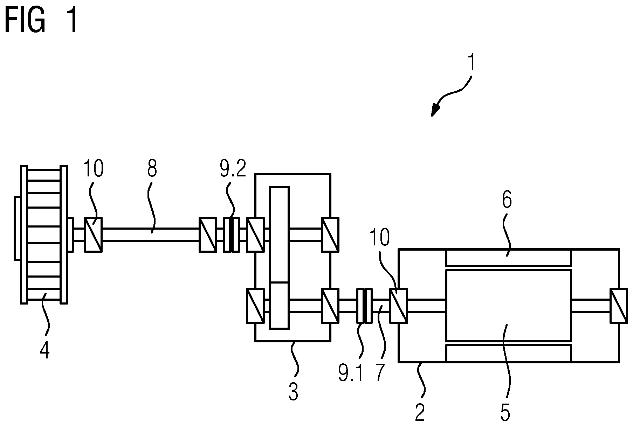

FIG 1 zeigt schematisch eine elektrische Maschine 1 mit einem mit Drehstrom betriebenen Asynchronmotor 2, der über ein Getriebe 3 ein Schwungrad 4 antreibt. Der Asynchronmotor 2 weist einen Rotor 5 und einen Stator 6 auf und wird durch einen nicht dargestellten Umrichter gespeist.

Der Rotor 5 ist als ein Käfigläufer mit elektrisch leitenden Rotorstäben, die auch als Läuferstäbe bezeichnet werden, ausgebildet.

Der Asynchronmotor 2 ist über eine Abtriebswelle 7 und eine erste Kupplungseinheit 9.1 mit dem Getriebe 3 verbunden. Das Getriebe 3 und das Schwungrad 4 sind über eine Antriebswelle 8 und eine zweite Kupplungseinheit 9.2 miteinander verbunden. Die Abtriebswelle 7 und die Antriebswelle 8 sind in Lagern 10 gelagert.

An einer derartigen elektrischen Maschine 1 können unterschiedliche Schäden auftreten. Dazu zählen Rotorstabbrüche von Rotorstäben des Rotors 5, Feldasymmetrien eines elektrischen Feldes des Rotors 5, Exzentrizitäten des Rotors 5, d.h. Abweichungen der Ausrichtung der Rotorachse von einer Sollausrichtung, Statorwindungsschlüsse, d.h. Kurzschlüsse von Statorwindungen, Lagerschäden von Lagern 10, Ausrichtungsfehler von Komponenten einer Kupplungseinheit 9.1, 9.2, Getriebefehler des Getriebes 3, Schäden an der Abtriebswelle 7 oder der Antriebswelle 8 oder Unwuchten des Schwungrades 4. Derartige Schäden können den elektrischen Strom an einem Ausgang des Umrichters, der den Asynchronmotor 2 speist, beeinflussen und daher mittels des erfindungsgemäßen Verfahrens erkannt werden.

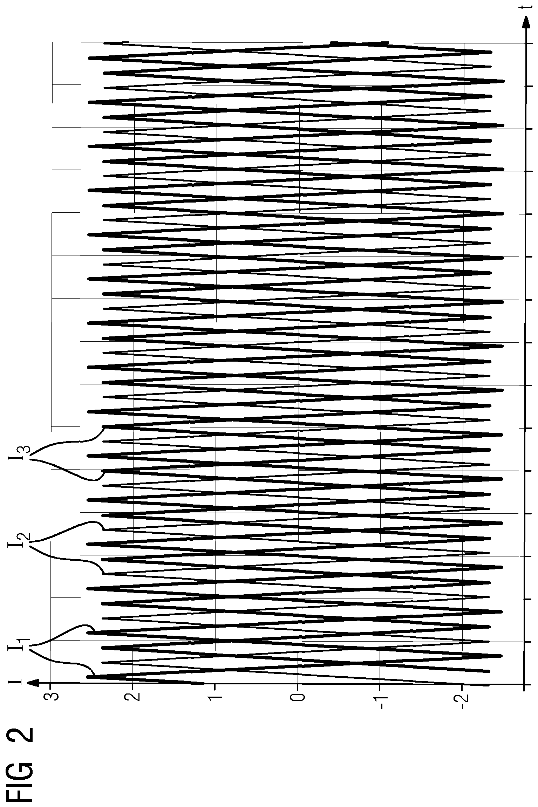

FIG 2 zeigt aufgenommene Stromsignaturen I₁, I₂, I₃ von Ausgangssignalen eines Umrichters, der einen in FIG 1 dargestellten Asynchronmotor 2 speist. Bei den Stromsignaturen I₁, I₂, I₃ handelt es sich jeweils um den Verlauf eines elektrischen Stromes I in Abhängigkeit von einer Zeit t, wobei die i.te Stromsignatur Iᵢ den zeitlichen Verlauf des i.ten Phasenstroms eines Drehstromes angibt (mit i = 1,2,3).

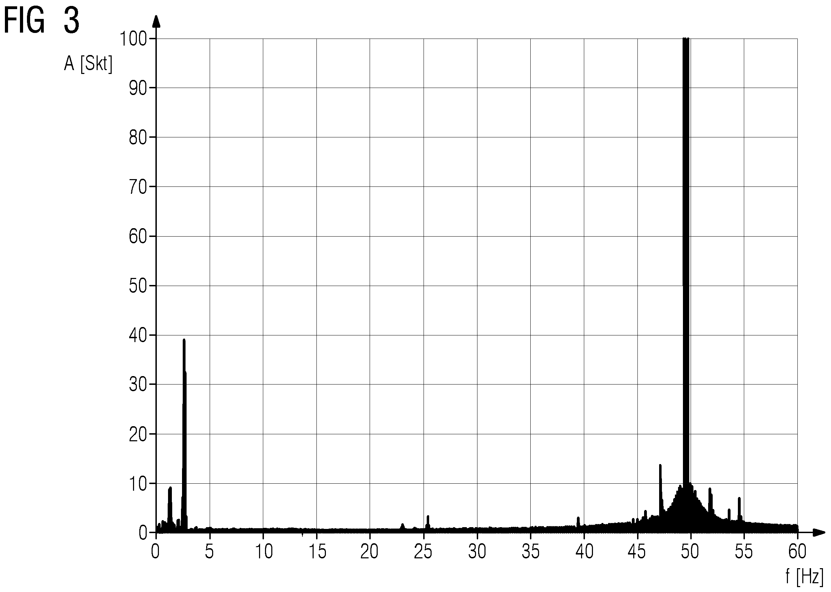

FIG 3 zeigt eine transformierte Stromsignatur A, die mittels einer schnellen Fourier-Transformation der in FIG 2 dargestellten ersten Stromsignatur I₁ bei einer schadensfreien elektrischen Maschine 1 erzeugt wird. Die transformierte Stromsignatur A wird als transformierte Referenzstromsignatur verwendet. Sie weist insbesondere ausgeprägte Maxima bei Frequenzen von etwa 2,5 Hz und 49,5 Hz auf.

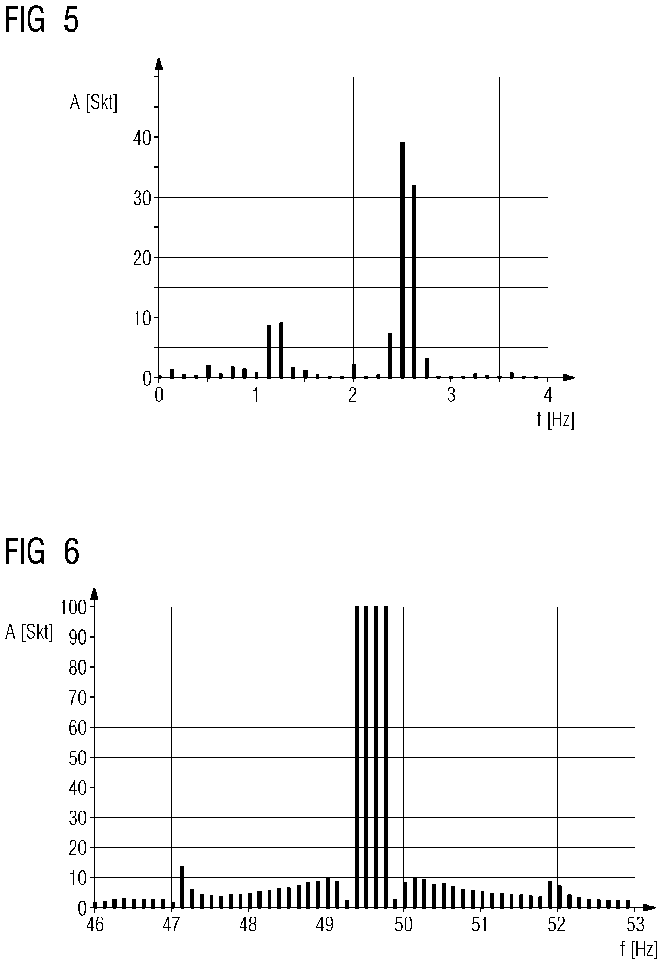

Die FIG 5 und 6 zeigen jeweils die transformierte Referenzstromsignatur in einem ersten Frequenzband von 0 Hz bis 4 Hz bzw. in einem zweiten Frequenzband von 46 Hz bis 53 Hz.

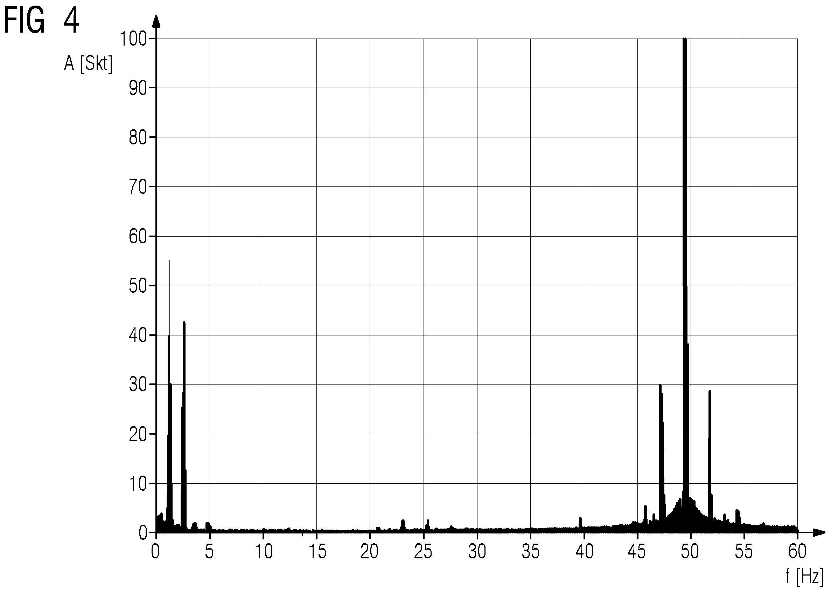

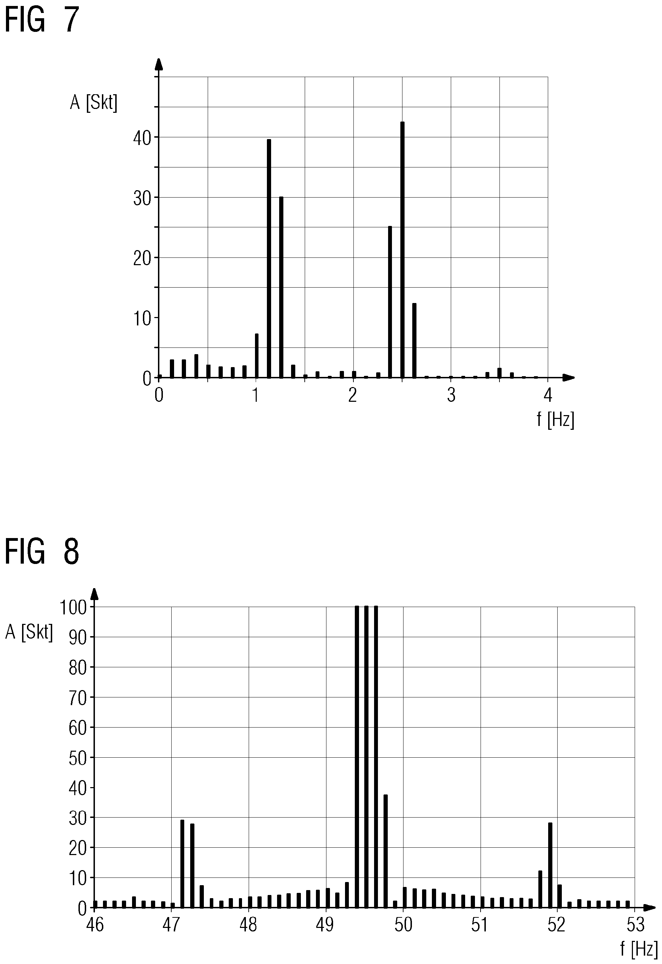

FIG 4 zeigt eine entsprechende transformierte Stromsignatur A der in FIG 2 dargestellten ersten Stromsignatur I₁, wobei der Asynchronmotor 2 der elektrischen Maschine 1 einen Rotor 5 mit einem gebrochenen Rotorstab aufweist. Die FIG 7 und 8 zeigen jeweils diese transformierte Stromsignatur A in dem ersten Frequenzband von 0 Hz bis 4 Hz bzw. in dem zweiten Frequenzband von 46 Hz bis 53 Hz.

Die in den FIG 4, 7 und 8 gezeigte transformierte Stromsignatur A unterscheidet sich von der in den FIG 3, 5 und 6 gezeigten transformierten Referenzstromsignatur vor allem durch deutlich verstärkte Nebenmaxima des Maximums bei etwa 49,5 Hz, die bei Frequenzen von etwa 47 Hz und 52 Hz auftreten, sowie ein deutlich verstärktes Maximum bei etwa 1 Hz. Diese verstärkten Maxima werden durch den Rotorstabbruch verursacht und ermöglichen es, den Rotorstabbruch mittels der transformierten Stromsignatur A zu erkennen.

Andere Schäden an der elektrischen Maschine 1 können entsprechend durch für sie jeweils charakteristische Abweichungen von der in den FIG 3, 5 und 6 gezeigten Referenzstromsignatur erkannt werden.

Bei den in den FIG 3 bis 8 gezeigten transformierten Stromsignaturen A handelt es sich um schnelle Fourier-Transformationen der Stromsignatur I₁ eines Phasenstromes. Wie oben bereits ausgeführt wurde, kann das erfindungsgemäße Verfahren auf verschiedene Weisen abgewandelt und ausgestaltet werden. Insbesondere kann aus den Stromsignaturen I₁, I₂, I₃ der drei Phasenströme eine symmetrische Komponente, insbesondere ein Gegensystem, gebildet und entsprechend ausgewertet werden. Zusätzlich kann vorteilhaft eine Amplitudendemodulation durchgeführt werden. Ferner kann der Umrichterstrom in einen felderzeugenden Anteil und einen drehmomenterzeugenden Anteil zerlegt werden und einer oder beide dieser Anteile analysiert werden.

Obwohl die Erfindung im Detail durch ein bevorzugtes Ausführungsbeispiel näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen. Der Schutzumfang wird durch die Ansprüche definiert.

## Patentansprüche

1. Verfahren zur Überwachung und Fehlerdiagnose einer rotierenden elektrischen Maschine (1), die durch einen Umrichter gespeist wird, wobei eine Stromsignatur (I₁, I₂, I₃) von Ausgangssignalen des Umrichters aufgenommen wird, eine Transformation der Stromsignatur (I₁, I₂, I₃) durchgeführt wird und die transformierte Stromsignatur (A) in zumindest einem Frequenzband zur Erkennung eines Schadens an der Maschine (1) ausgewertet wird, wobei die Transformation der Stromsignatur (I₁, I₂, I₃) wenigstens eine schnelle Fourier-Transformation unter Verwendung einer Filterfunktion umfasst,
wobei eine transformierte Referenzstromsignatur ermittelt wird, die einen schadensfreien Zustand der Maschine (1) repräsentiert, und dass die transformierte Stromsignatur (A) bei der Auswertung mit der transformierten Referenzstromsignatur verglichen wird,
wobei zur Erkennung eines Schadens an der Maschine (1) in einem Wertebereich der transformierten Stromsignatur (A) ein frequenzabhängiges Toleranzband vorgegeben wird und auf einen Schaden geschlossen wird, wenn die transformierte Stromsignatur (A) bei wenigstens einer Frequenz außerhalb des Toleranzbandes liegt.

2. Verfahren nach den Anspruch 1,
**dadurch gekennzeichnet, dass** das Toleranzband so vorgegeben wird, dass die transformierte Referenzstromsignatur innerhalb des Toleranzbandes liegt.

3. Verfahren nach einem der vorhergehenden Ansprüche,
**dadurch gekennzeichnet, dass** für wenigstens eine Schadensart eine schadensspezifische transformierte Stromsignatur (A) ermittelt wird, und dass die transformierte Stromsignatur (A) bei der Auswertung mit wenigstens einer schadensspezifischen transformierten Stromsignatur (A) verglichen wird.

4. Verfahren nach Anspruch 3,
**dadurch gekennzeichnet, dass** eine schadensspezifische transformierte Stromsignatur (A) wenigstens für einen Rotorstabbruch eines Rotors (5) der Maschine (1) oder eine Feldasymmetrie des Rotors (5) oder eine Exzentrizität des Rotors (5) oder einen Statorwindungsschluss eines Stators (6) der Maschine (1) oder einen Schaden eines Antriebsstranges der Maschine (1) ermittelt wird.

5. Verfahren nach einem der vorhergehenden Ansprüche,
**dadurch gekennzeichnet, dass** für einen dreiphasigen Umrichterstrom alle drei Phasenströme aufgenommen werden und die Transformation der Stromsignatur (I₁, I₂, I₃) die Bildung einer symmetrischen Komponente aus den drei Phasenströmen umfasst.

6. Verfahren nach einem der vorhergehenden Ansprüche,
**dadurch gekennzeichnet, dass** die Transformation der Stromsignatur (I₁, I₂, I₃) eine Amplitudendemodulation umfasst.

7. Verfahren nach Anspruch 6,
**dadurch gekennzeichnet, dass** die Amplitudendemodulation mit einer Hilberttransformation der fouriertransformierten Stromsignatur durchgeführt wird.

8. Verfahren nach einem der vorhergehenden Ansprüche,
**dadurch gekennzeichnet, dass** die Maschine (1) laufend und automatisch überwacht wird, und dass automatisch eine Fehlermeldung generiert und/oder ein Alarm ausgelöst wird, wenn ein Schaden an der Maschine (1) erkannt wird.

## Claims

1. Method for monitoring and fault diagnosis of a rotating electric machine (1) which is fed by a converter, wherein a current signature (I₁, I₂, I₃) of output signals of the converter is recorded, a transformation of the current signature (I₁, I₂, I₃) is carried out and the transformed current signature (A) is evaluated in at least one frequency band in order to detect damage to the machine (1), wherein the transformation of the current signature (I₁, I₂, I₃) comprises at least one fast Fourier transform using a filter function, wherein a transformed reference current signature is ascertained which represents a damage-free state of the machine (1), and that the transformed current signature (A) is compared during the evaluation with the transformed reference current signature,
wherein in order to detect damage to the machine (1) a frequency-dependent tolerance band is predetermined in a value range of the transformed current signature (A) and damage is concluded to have occurred if the transformed current signature (A) lies outside the tolerance band in the case of at least one frequency.

2. Method according to claim 1,
**characterised in that** the tolerance band is predetermined such that the transformed reference current signature lies within the tolerance band.

3. Method according to one of the preceding claims,
**characterised in that** a damage-specific transformed current signature (A) is ascertained for at least one damage type, and that during the evaluation the transformed current signature (A) is compared with at least one damage-specific transformed current signature (A).

4. Method according to claim 3,
**characterised in that** a damage-specific transformed current signature (A) is ascertained at least for a broken rotor bar of a rotor (5) of the machine (1) or field asymmetry of the rotor (5) or eccentricity of the rotor (5) or a stator winding short-circuit of a stator (6) of the machine (1) or damage to a drive train of the machine (1).

5. Method according to one of the preceding claims,
**characterised in that** all three phase currents are recorded for a three-phase converter current and the transformation of the current signature (I₁, I₂, I₃) comprises the formation of a symmetrical component from the three phase currents.

6. Method according to one of the preceding claims,
**characterised in that** the transformation of the current signature (I₁, I₂, I₃) comprises an amplitude demodulation.

7. Method according to claim 6,
**characterised in that** the amplitude demodulation is carried out with a Hilbert transform of the Fourier transformed current signature.

8. Method according to one of the preceding claims,
**characterised in that** the machine (1) is monitored continuously and automatically, and that a fault report is automatically generated and/or an alarm is automatically triggered if damage to the machine (1) is detected.

## Revendications

1. Procédé de contrôle et de diagnostic d'un défaut d'une machine (1) électrique tournante, que l'on alimente par un onduleur, dans lequel on reçoit une signature (I₁, I₂, I₃) de courant par des signaux de sortie de l'onduleur, on effectue une transformation de la signature (I₁, I₂, I₃) de courant et on exploite la signature (A) de courant transformé dans au moins une bande de fréquence pour reconnaître une détérioration de la machine (1), la transformation de la signature (I₁, I₂, I₃) de courant comprenant au moins une transformation de Fourier rapide en utilisant une fonction de filtrage,
dans lequel on détermine une signature de courant de référence transformée, qui représente un état sans dommage de la machine (1) et en ce que l'on compare la signature (A) de courant transformée lors de l'exploitation à la signature de courant de référence transformée,
dans lequel pour reconnaître un endommagement de la machine (1) on prescrit dans une plage de valeur de la signature (A) de courant transformée une bande de tolérance, qui dépend de la fréquence, et on déduit un endommagement si la signature (A) de courant transformée se trouve, pour au moins une fréquence, à l'extérieur de la bande de tolérance.

2. Procédé suivant la revendication 1,
**caractérisé en ce que** l'on prescrit la bande de tolérance de manière à ce que la signature de courant de référence transformée se trouve dans la bande de tolérance.

3. Procédé suivant l'une des revendications précédentes,
**caractérisé en ce que** pour au moins un type d'endommagement, on détermine une signature (A) de courant transformée spécifique à l'endommagement et **en ce que** l'on compare la signature (A) de courant transformée lors de l'exploitation à au moins une signature (A) de courant transformée spécifique à l'endommagement.

4. Procédé suivant la revendication 3,
**caractérisé en ce que** on détermine une signature (A) de courant transformée spécifique à un endommagement au moins pour une rupture d'un rotor (5) de la machine (1) ou une asymétrie du champ du rotor (5) ou une excentricité du rotor (5) ou un court-circuit entre spires d'un stator (6) de la machine (1) ou un endommagement d'une chaîne cinématique de la machine (1).

5. Procédé suivant l'une des revendications précédentes,
**caractérisé en ce que** pour un courant d'onduleur triphasé, on enregistre tous les trois courants de phase et la transformation de la signature (I₁, I₂, I₃) de courant comprend la formation d'une composante symétrique composée des trois courants de phase.

6. Procédé suivant l'une des revendications précédentes, **caractérisé en ce que** la transformation de la signature (I₁, I₂, I₃) de courant comprend une modulation de l'amplitude.

7. Procédé suivant la revendication 6,
**caractérisé en ce que** l'on effectue la modulation de l'amplitude par une transformation de Hilbert de la signature de courant à transformée de Fourier.

8. Procédé suivant l'une des revendications précédentes,
**caractérisé en ce que** l'on contrôle la machine (1) en continu et automatiquement et **en ce que** l'on produit automatiquement un message de défaut et/ou on déclenche une alerte si l'on reconnaît un endommagement de la machine (1).
